# EUROPÄISCHE PATENTSCHRIFT

(11) **EP 0 886 819 B1**
(45) Veröffentlichungstag und Bekanntmachung des Hinweises auf die Patenterteilung: **15.09.1999**
(21) Anmeldenummer: 97915345.9
(22) Anmeldetag: 12.03.1997
(51) Int. Cl.: G06F 1/18, H05K 7/14

(54) **HALTEVORRICHTUNG FÜR DEN MONTAGEWINKEL VON STECKKARTEN BZW. STANDARD-FLACHBAUGRUPPEN**
SECURING DEVICE FOR ASSEMBLY BRACKETS OF PLUG-IN CARDS AND STANDARD FLAT MODULES
SYSTEME DE RETENUE POUR PATTE DE FIXATION DE CARTES ENFICHABLES OU DE BLOCS DE COMPOSANTS PLATS STANDARD

(30) Priorität: 12.03.1996 DE 29604610 U
(43) Veröffentlichungstag der Anmeldung: 30.12.1998
(73) Patentinhaber: Siemens Nixdorf Informationssysteme AG, 33106 Paderborn (DE)
(72) Erfinder: KÖHLER, Friedrich, D-86405 Meitingen (DE); MYSZ, Dietmar, D-86199 Augsburg (DE)
(74) Vertreter: Epping, Wilhelm, Dr.-Ing.
(86) Internationale Anmeldenummer: DE9700492
(87) Internationale Veröffentlichungsnummer: WO9734216

(56) Entgegenhaltungen:
- DE-A- 4 403 907
- US-A- 4 873 395

## Beschreibung

Die Erfindung betrifft eine Haltevorrichtung gemäß den Merkmalen des Oberbegriffs des Anspruchs 1.

Standard-Flachbaugruppen, insbesondere die in der Computer-technik eingesetzten Steckkarten, werden üblicherweise mit Hilfe von Montagewinkeln an entsprechend gestalteten Einbauplätzen montiert. An diesen Montagewinkeln ist jeweils wenigstens ein Steckverbinder befestigt, der die Verbindung der Steckkarte zu externen Anschlüssen herstellt. Die Gehäusewandung weist deshalb an den Einbauplätzen jeweils schlitzartige Aussparungen auf, die von dem jeweiligen Montagewinkel abgedeckt werden. Am Montagewinkel ist ferner ein rechtwinklig angesetzter Halteflansch vorgesehen, der sich an einer entsprechend abgewinkelten Stützfläche der Gehäusewandung anschmiegt und dort mittels einer Schraub- oder Klemmverbindung lösbar fixiert wird.

So ist beispielsweise aus DE 44 03 907 A1 eine Haltevorrichtung in Form einer alle einsteckbaren Flachbaugruppen bzw. deren Montagewinkel übergreifenden Klemmleiste bekannt, die im eingesetzten Zustand alle Steckkarten fixiert und die im Freigabezustand alle Steckkarten freigibt, und die elastische Bereiche aufweist, die den einzelnen Steckkarten zugeordnet sind. Nachteilig dabei ist, daß unabhängig von der Zahl der belegten Einbauplätze stets eine alle Einbauplätze erfassende entsprechend breite Klemmleiste erforderlich ist und daß beim Nachrüsten oder Auswechseln die Befestigung für alle übrigen an sich nicht betroffenen Flachbaugruppen zwischenzeitlich gelockert werden muß.

Der vorliegenden Erfindung liegt nun die Aufgabe zugrunde, für die Befestigung des Montagewinkels von Steckkarten eine möglichst einfache und auch einfach handhabbare Vorrichtung anzugeben, die eine individuelle zuverlässige Befestigung jeder einzelnen Standard-Flachbaugruppe am Gehäuse ermöglicht.

Die Lösung dieser Aufgabe ergibt sich erfindungsgemäß durch die Merkmale des Anspruchs 1. Vorteilhafte Weiterbildungen der Erfindung sind in Unteransprüchen angegeben.

Im folgenden wird ein Ausführungsbeispiel der Erfindung anhand der Zeichnungen näher erläutert. Dabei zeigen
Figur 1 einen Ausschnitt aus einer Gehäusewandung eines Rechnergehäuses mit einer Haltevorrichtung gemäß der Erfindung in perspektivischer Darstellung,
Figur 2 das Klemmelement als Bestandteil der Vorrichtung gemäß Figur 1,
Figuren 3, 4 die Haltevorrichtung gemäß Figur 1 im Zeitpunkt der Montage bzw. nach der Montage.

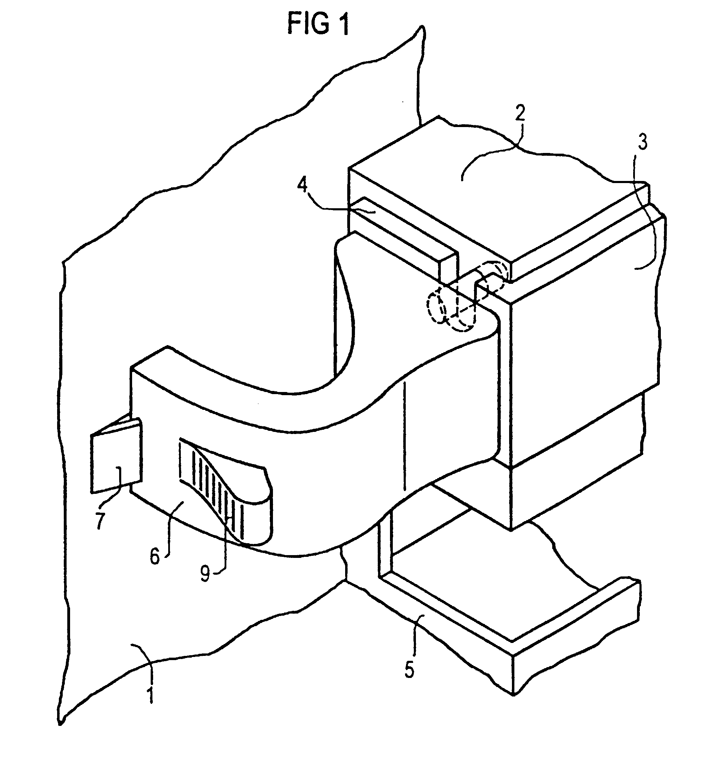

Die Figur 1 zeigt einen Ausschnitt einer Gehäuserückwand 1 eines PC-Gehäuses, das im Bereich zweier Einbauplätze für Steckkarten eine etwa rechteckförmige Einbuchtung 2 aufweist. An den parallel zueinander angeordneten Einbauplätzen in Form schlitzartiger Aussparungen sind jeweils L-förmige Montagewinkel 3 einer Steckkarte bzw. bei nichtbelegten Einbauplätzen zu diesen Montagewinkeln baugleiche Abdeckwinkel befestigt. Die Befestigung des Montagewinkels 3 bzw. des baugleichen Abdeckwinkels erfolgt an dessem rechtwinklig abgebogenen Halteflansch 4, der sich an einer durch die Einbuchtung 2 gebildeten seitlichen Stützwand 5 der Gehäusewandung 1 anschmiegt. Als Ersatz für die üblicherweise vorgesehene Schraubverbindung ist eine Klemmvorrichtung 6 vorgesehen, die aus einem bügelartigen Federelement besteht, wobei sich dieses Federelement mit den Bügelenden an der Gehäusewandung 1 abstützt und zwischen dem Halteflansch 4 einerseits und einem an der Gehäusewandung 1 vorgesehenen Rastelement 7 andererseits einschnappbar ist. Als Rastelement 7 ist beispielsweise eine aus der Gehäusewandung 1 herausgerissene Blechlasche vorgesehen.

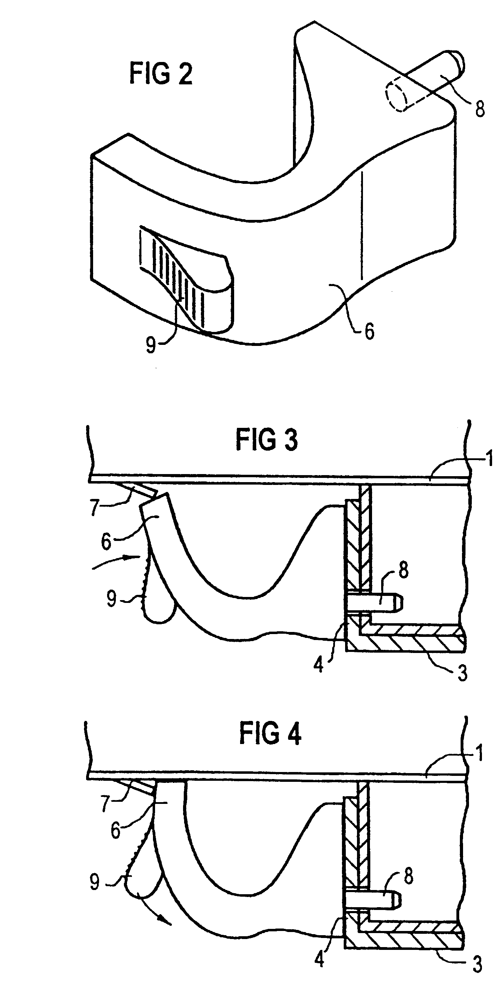

Einzelheiten der in der Haltevorrichtung gemäß Figur 1 verwendeten Klemmvorrichtung 6 ergeben sich aus der Darstellung in Figur 2. Diese beispielsweise aus Kunststoff bestehende Klemmvorrichtung weist an der dem Halteflansch 4 des Montagewinkels 3 (siehe Figur 1) zugewandten Seite einen Zentrierdorn 8 auf, der durch eine U-förmige Kerbe im Montagewinkel in eine lochartige Aussparung in der Stützfläche 5 der Gehäusewandung 1 eintaucht, wodurch der Montagewinkel über die Klemmung hinaus zusätzlich fixiert wird. Die dem Halteflansch 4 zugewandte Seite der Klemmvorrichtung weist eine zum Halteflansch planparallele Fläche auf.

Die Montage bzw. die endgültige Fixierung der Klemmvorrichtung ist aus den Figuren 3 und 4 ersichtlich. Als Montagehilfsmittel dient ein nasenartig vorspringendes Griffelement 9, das an dem dem Halteflansch abgewandten Bereich des bügelartigen Federelements angeformt ist. Durch leichten Daumendruck in Richtung Halteflansch wird das vorzugsweise aus elastischem Kunststoff bestehende Federelement soweit zusammengedrückt, daß der dem Halteflansch abgewandte Bügel hinter dem Rastelement 7 in der Gehäusewandung 1 eintaucht und beim Loslassen des Griffelements festklemmt. Die Figur 4 zeigt die Klemmvorrichtung im montierten Zustand, wobei der Federbügel zwischen Halteflansch 4 und Rastelement 7 eingespannt und durch den in die Stützwand 5 eintauchenden Zentrierdorn 8 lagerichtig fixiert ist.

## Patentansprüche

1. Haltevorrichtung für den Montagewinkel von Standard-Flachbaugruppen, die mit dem Montagewinkel an Einbauplätzen in Form schlitzartiger Aussparungen in einer Gehäusewandung eines Datenverarbeitungsgerätes lösbar befestigt sind, derart, daß der an einer abgewinkelten Stützfläche der Gehäusewandung anliegende, entsprechend abgewinkelte Halteflansch des Montagewinkels mittels einer Klemmvorrichtung fixierbar ist, **dadurch gekennzeichnet,** daß jedem Halteflansch (4) eine individuelle aus einem bügelartigen Federelement bestehende Klemmvorrichtung (6) zugeordnet ist, daß sich das Federelement der jeweiligen Klemmvorrichtung mit den Bügelenden an der Gehäusewandung (1) abstützt und, daß das Federelement zwischen dem Halteflansch (4) des Montagewinkels (3) und jeweils einem an der Gehäusewandung (1) vorgesehenen Rastelement (7) einschnappbar ist.

2. Haltevorrichtung nach Anspruch 1, **dadurch gekennzeichnet,** daß die Klemmvorrichtung (6) aus elastischem Kunststoff besteht.

3. Haltevorrichtung nach Anspruch 1 oder 2, **dadurch gekennzeichnet,** daß die Klemmvorrichtung (6) an der dem Halteflansch (4) zugewandten Seite einen Zentrierdorn (8) aufweist, der durch eine U-förmige Kerbe im Montagewinkel (3) in eine lochartige Aussparung in der Stützfläche (5) der Gehäusewandung (1) eintaucht.

4. Haltevorrichtung nach einem der vorhergehenden Ansprüche, **dadurch gekennzeichnet,** daß die dem Halteflansch (4) zugewandte Seite der Klemmvorrichtung (6) als zum Halteflansch (4) planparallele Fläche ausgebildet ist.

5. Haltevorrichtung nach einem der vorhergehenden Ansprüche, **dadurch gekennzeichnet,** daß an dem dem Halteflansch (4) abgewandten Bereich des bügelartigen Federelements ein nasenartig vorspringendes Griffelement (9) vorgesehen ist.

## Claims

1. Securing device for the assembly bracket of standard flat components which are releasably secured by the assembly bracket at mounting locations in the form of slot-like clearances in a housing wall of a data-processing device in such a way that the securing flange of the assembly bracket lying against an angled support surface of the housing wall and correspondingly angled can be fixed by means of a clamp device, characterized in that each securing flange (4) is assigned an individual clamp device (6) comprising a bow-like spring element, in that the spring element of the respective clamp device is supported with the bow ends on the housing wall (1), and in that the spring element can be snapped in between the securing flange (4) of the assembly bracket (3) and a respective catch element (7) provided on the housing wall (1).

2. Securing device according to Claim 1, characterized in that the clamp device (6) consists of flexible plastic.

3. Securing device according to Claim 1 or 2, characterized in that the clamp device (6) has on the side facing the securing flange (4) a centring pin (8), which enters through a U-shaped notch in the assembly bracket (3) into a hole-like clearance in the support surface (5) of the housing wall (1).

4. Securing device according to one of the preceding claims, characterized in that the side of the clamp device (6) facing the securing flange (4) is designed as a surface which is plane-parallel to the securing flange (4).

5. Securing device according to one of the preceding claims, characterized in that a gripping element (9) which projects in a nose-like manner is provided at the region of the bow-like spring element facing away from the securing flange (4).

## Revendications

1. Système de retenue pour la patte de fixation de blocs de composants plats standard, qui sont fixés par cette patte de fixation de manière détachable en des emplacements sous la forme d'évidements du genre fentes dans une paroi de boîtier d'un appareil de traitement de données, de telle sorte que la bride de retenue de la patte de fixation, bride qui s'applique contre une face d'appui coudée de la paroi de boîtier et est coudée d'une manière correspondante, peut être immobilisée au moyen d'un dispositif de serrage, **caractérisé** en ce qu'un dispositif (6) de serrage individuel, constitué d'un élément élastique du genre étrier, est associé à chaque bride (4) de retenue, en ce que l'élément élastique du dispositif de serrage respectif s'appuie par les extrémités de l'étrier contre la paroi (1) de boîtier, et en ce que l'élément élastique peut être encliqueté entre la bride (4) de retenue de la patte (3) de fixation et un élément (7) respectif d'encliquetage prévu sur la paroi (1) de boîtier.

2. Système de retenue suivant la revendication 1, **caractérisé** en ce que le dispositif (6) de serrage est réalisé en matière plastique élastique.

3. Système de retenue suivant la revendication 1 ou 2, **caractérisé** en ce que le dispositif (6) de serrage comporte, sur le côté tourné vers la bride (4) de retenue, un téton (8) de centrage qui s'enfonce, par une encoche en forme de U dans la patte (3) de fixation, dans un évidement du genre trou dans la face (5) d'appui de la paroi (1) de boîtier.

4. Système de retenue suivant l'une des revendications précédentes, **caractérisé** en ce que le côté du dispositif (6) de serrage qui est tourné vers la bride (4) de retenue est réalisé sous forme de face plane et parallèle à la bride (4) de retenue.

5. Système de retenue suivant l'une des revendications précédentes, **caractérisé** en ce qu'il est prévu, sur la région de l'élément élastique du genre étrier qui est opposée à la bride (4) de retenue, un élément (9) de préhension saillant du genre bec.
